# EUROPEAN PATENT SPECIFICATION

(11) **EP 3 510 635 B1**
(45) Date of publication and mention of the grant of the patent: **31.01.2024**
(21) Application number: 16770003.8
(22) Date of filing: 21.09.2016
(51) Int. Cl.: H01L 23/367, H01L 23/467, F28F 3/04, F28F 13/06

(54) **HEATSINK**
KÜHLKÖRPER
DISSIPATEUR THERMIQUE

(43) Date of publication of application: 17.07.2019
(73) Proprietor: Huawei Technologies Co., Ltd., Longgang District Shenzhen, Guangdong 518129 (CN)
(72) Inventor: KALLMARK, Magnus, 164 40 Kista (SE)
(74) Representative: Gill Jennings & Every LLP
(86) International application number: PCT/EP2016/072440
(87) International publication number: WO 2018/054462

(56) References cited:
- WO-A1-99/27761
- WO-A1-2015/145809
- JP-A- 2005 303 063
- US-A1- 2005 034 845
- US-A1- 2013 175 021
- US-B1- 6 847 525

## Description

### TECHNICAL FIELD

The present disclosure relates to a heatsink for natural convection cooling and more particularly to a heatsink for natural convection cooling with a plurality of plate fins.

### BACKGROUND

A heatsinks for natural convection is a passive heat exchanger that transfers the heat generated by an electronic or a mechanical device to air. A natural convection heatsink transfers thermal energy from a higher temperature device to a lower temperature surrounding air. A heatsink for natural convection is designed to maximize its surface area in contact with the air surrounding it. Air velocity, choice of material, protrusion design and surface treatment are factors that affect the performance of a heatsink.

A natural convection heatsink is typically made out of copper and/or aluminum. Copper is used because it has many desirable properties for thermally efficient and durable heat exchangers. First and foremost, copper is an excellent conductor of heat. This means that copper's high thermal conductivity allows heat to pass through it quickly. Aluminum is used in applications where weight is a big concern.

Natural convection heatsinks are provided with plate fins in order to increase the surface area of the heatsink. In general, the more surface area the heatsink has, the better it works. The shape of fins must be optimized to maximize, heat flux, i.e. heat transfer density and to maximize convective flow of air across the heatsink where space, weight and the materials used for the finned surfaces are constraints.

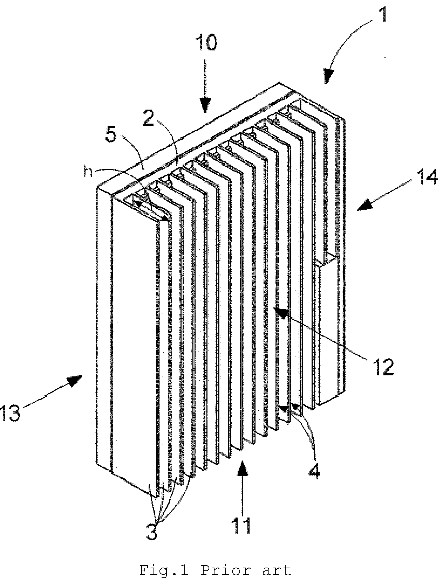

A known type of natural convection heatsink is the straight fin heatsink 1 shown in Fig. 1. The plate fins 3 run in parallel the entire length of the heatsink 1 with a channel 4 in between pairs of neighboring plate fins 3. The plate fins 3 extend perpendicular over a height h from a base 2. The main lateral side 12 can be covered or be open. A secondary lateral side 13 and a tertiary lateral side 14 of the heatsink 1 are formed by the outermost plate fins 3. Air can enter from the bottom side 11 and exit from the top side 10. The heatsink 1 is shown mounted on a printed circuit board 5.

Straight plate fin natural convection heatsinks 1 perform best when used in their intended application/orientation where the convective airflow is parallel with the straight plate fins 3, i.e. the orientation of the heatsink 1 shown in Fig. 1 where the straight plate fins 3 extend parallel with the direction of the gravitational pull of the earth and with the top face 10 facing substantially upwards relative to the direction of the gravitational pull of the earth and the bottom face 11 facing substantially downwards relative to the direction of the gravitational pull of the earth.

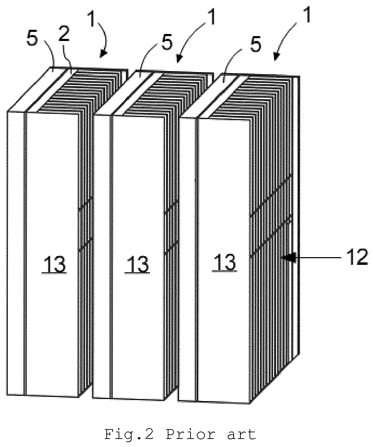

A problem with known natural convection heatsinks as shown in Fig. 1, is that they are optimized for ideal scenarios where only one heatsink 1 is placed alone, hereinafter named stand alone, whereas often several printed circuit boards, each provided with a heatsink are placed close to each other in a parallel "blade" arrangement shown in Fig. 2. In such a blade arrangement the printed circuit boards 5 are arranged vertically, with the blade fins 3 of the heatsinks 1 on the printed circuit boards 5 also extending vertically. Due to the close arrangement between the printed circuit boards 5, the heatsinks 1 that sandwiched between two neighboring printed circuit boards 5 have constraints in taking in air via the main lateral side 12 since this is where the neighboring printed circuit board 5 is placed. Thus, in this prior art arrangement the heatsinks 1 that are sandwiched between printed circuit boards 5 have air entering the channels 4 between the plate fins only from the bottom face 11 of the heatsink 1.

WO 2015/145809 A1 describes a servo amplifier having a heat sink. US 2013/0175021 A1 describes a heat sink device. US 2005/034845 A1 describes a cooling device having fins arranged to funnel air. US 6 847 525 B1 describes a forced convection heat sink system. WO 99/27761 A1 describes a cooling element for an unevenly distributed heat load.

### SUMMARY

In accordance with the invention, there is provided a heatsink and an assembly as set forth in the claims.

It is an object of the invention to provide a heatsink for natural convection cooling with improved capacity to dissipate heat to the surrounding air.

The foregoing and other objects are achieved by the features of the independent claims. Further implementation forms are apparent from the dependent claims, the description and the figures.

According to a first aspect, there is provided a heatsink for natural convection cooling, the heatsink comprising:
a plurality of spaced plate fins projecting from a base with a given height, the plate fins having a given length and the plate fins being arranged to occupy a given space,
the given space having a bottom side, a top side, a main lateral side connecting the top side and the bottom side and at least secondary lateral side connecting the top side and the bottom side,
a channel for allowing air to flow along the plate fins, the channel being formed between pairs of neighboring plate fins with a bottom of the channel being formed by the base and the channels being open or closed along part or all of their length to the main lateral side,
at least one pair of neighboring plate fins forms a channel of a first type that extends between the bottom side and the top side, and
at least one pair of neighboring plate fins forms a channel of a second type that extends between the secondary lateral side and the top side.

In known heatsinks of the straight parallel fin design the lateral sides are closed by the laterally outermost plate fins, thus preventing air from entering the heatsink from the lateral sides and only allowing air to enter from the top or bottom and possibly from the primary lateral side. By arranging some of the plate fins to extend from the secondary lateral side towards the top side it becomes possible to increase the air intake by intake via the bottom side and the secondary lateral side of the heatsink.

The channel of a first type opens to the bottom side and to the top side, and the channel of a second type opens to the secondary lateral side and to the top side. Thus, a channel can open to a corner of the given space.

At least one of the plate fins of the plurality spaced plate fins is a plate fin of a first type that extends lengthwise from the bottom side to the top side. Thus, a channels over the full extent of the given space are created.

At least one of the plate fins of the plurality spaced plate fins being plate fins of a second type that extends lengthwise from the secondary lateral side into the given space in a direction that includes a component towards the top side. Thus the channels defined by the plate fins concerned extend in an essentially upwards direction, e.g. allowing convective air flow.

In a fourth possible implementation form of the first aspect at least one of the plate fins of the second type extends from the secondary lateral side to the top side. Thus, channels are formed that extend from the secondary lateral side to the top side.

A portion the plate fins of both the first type plate fins and the second type plate fins in a upper portion of the heatsink closest to the top side extend parallel with one another in a direction that is preferably substantially perpendicular to the top side. Thus, an upper portion of the heat sink can be shaped in a conventional manner.

In a sixth possible implementation form of the first aspect the heatsink comprises a plate fin that extends lengthwise from the secondary lateral side or from the bottom side and terminates before reaching another side of the given space. Thus, plate fines with a reduced length, that allow channels to merge can be formed.

In a seventh possible implementation form of the first aspect the plate fins are secured to a first side of the base and wherein a plate fin preferably extends parallel with the normal vector to the first side at the position where a plate fin concerned is secured to the base. Thus, a seat sink is provided that can be molded in one piece.

The given space comprises a tertiary lateral side, the tertiary lateral side opposing the secondary lateral side. Thus, a further side for air influx is provided.

In a ninth possible implementation form of the first aspect at least one pair of neighboring plate fins form a channel of a third type that extends between the tertiary lateral side and the top side. Thus, air influx from a further lateral side is made possible.

In a tenth possible implementation form of the first aspect the channel of a third type opens to the tertiary lateral side and to the top side. Thus, the air can enter into the third type channels from the tertiary lateral side.

The main lateral side connects the secondary lateral side and the tertiary lateral side. Thus, another side of the given space is defined.

In a twelfth possible implementation form of the first aspect the plate fins extend from the base to main lateral side.

In a thirteenth possible implementation form of the first aspect the heatsink is provided with means for ensuring that the heatsink can only be installed in one intended orientation. Thus, installing the heat sink in a wrong orientation is prevented.

In a fourteenth possible implementation form of the first aspect the intended orientation is with the top face facing substantially upwards relative to the direction of the gravitational pull of the earth and the bottom face facing substantially downwards relative to the direction of the gravitational pull of the earth, the secondary lateral face preferably extending substantially parallel with the direction of the gravitational pull of the earth. Thus, the plate fins will be properly oriented for enabling a convective flow of air through the channels.

In a fifteenth possible implementation form of the first aspect the given space has substantially the shape of a cuboid. A cuboid uses available space effectively in a setting where the surrounding elements also have cuboid shapes and are in a staggered arrangement.

In a sixteenth possible implementation form of the first aspect the given space has the shape of a cuboid with rounded edges and/or with curved sides. Thus, sharp edges can be avoided.

In a seventeenth possible implementation form of the first aspect the bottom side is flat or planar. A flat or planar bottom allows for a heatsink with regular proportions.

In an eighteenth possible implementation form of the first aspect the main lateral side is curved, flat or stepped, and/or wherein the secondary lateral side is curved, flat and/or stepped, and/ or wherein the top side is curved, flat and/or stepped and/ or wherein the first side is curved, flat and/or stepped and/or wherein the tertiary lateral side is flat. Thus, further design options for the heatsink are provided,

In a nineteenth possible implementation form of the first aspect the plate fins extend substantially perpendicularly to the main lateral surface. This arrangement of the plate fins is space effective uncomplicated, also from a manufacturing perspective, e.g. manufacturing by molding.

According to a second aspect there is provided assembly of a plurality of adjacent heatsinks according to any one of the implementations of the first aspect. This assembly has the advantage that the printed circuit boards in e.g. a unit can be spaced close to one another while maintaining sufficient convective airflow through the heat sinks.

According to a first possible implementation of the second aspect the main lateral side of one heatsink faces the base of the neighboring heatsink. Thus, the heatsink is essentially sandwiched between two printed circuit boards, thereby optimizing use of available space.

According to a second possible implementation of the second aspect a first heatsink is mounted on first printed circuit board, and a second heatsink is mounted on a second printed circuit board, with the first and second printed circuit boards extending parallel with one another. Thus, an assembly is created that utilizes available space effectively.

These and other aspects of the invention will be apparent from and the embodiment(s) described below.

### BRIEF DESCRIPTION OF THE DRAWINGS

In the following detailed portion of the present disclosure, the invention will be explained in more detail with reference to the example embodiments shown in the drawings, in which:
Fig. 1 is an elevated view of a prior art heatsink,
Fig. 2 is an elevated view of a plurality of prior art heatsinks in a so-called blade arrangement,
Fig. 3 is an elevated view of a heatsink according to a first example embodiment,
Fig. 4 is a side view of the heatsink of Fig. 3,
Fig. 5 is an elevated view showing lateral and bottom faces of a plurality of heatsinks of Fig. 3 in a so-called blade arrangement,
Fig. 6 is an elevated view showing lateral and top faces of the plurality of heatsinks of Fig. 3 in a so-called blade arrangement,
Fig. 7 is a side view of a heatsink according to a second example embodiment
Fig. 8 is a side view of a heatsink according to a third example embodiment, and
Fig. 9 is a side view of a heatsink according to a fourth example embodiment.

### DETAILED DESCRIPTION

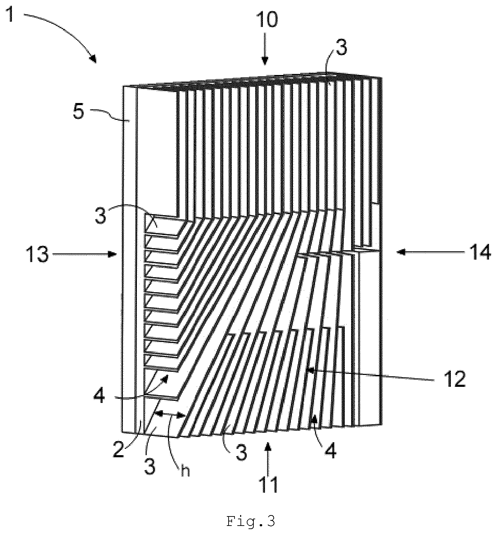

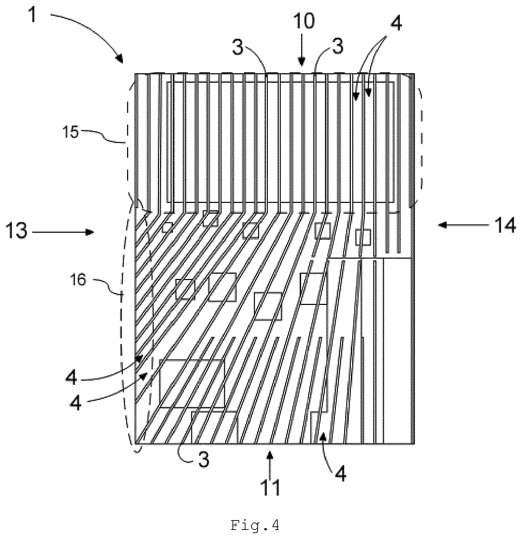

With reference to Figs. 3 and 4 heatsink 1 for natural convection cooling according to an example embodiment is shown in elevated and side view, respectively.

The heatsink 1 comprises a base 2 that supports a plurality of plate fins 3. The plate fins 3 project from the base 2 to a given height h. This height can be the same for all plate fins 3, as shown in this example embodiment, but this height can also vary between plate fins 3. The plate fins 3 extend from the base 2 to a primary lateral side 12. The plate fins 3 have a given length and the plate fins 3 are arranged to occupy a given space.

The given space is delimited by a bottom side 11, a top side 10, a main lateral side 12, a secondary lateral side 13 a tertiary lateral side 14 and the base 2.

The main lateral side 12 connects the top side 10 and the bottom side 11. The main lateral 12 side also connects the secondary lateral side 13 and the tertiary lateral side 14. In the present embodiment the given space is essentially in the form of a cuboid, but it is not a prerequisite for the given space to be arranged in the form of cuboid and it is not necessary for the sides to be arranged at right angles relative to one another.

The secondary lateral side 13 is shown in Figs. 3,4 and 7 to 9 on the left and the tertiary lateral side 14 is shown on the right. However, the secondary lateral side 13 could just as well be on the right and the tertiary lateral side 14 on the left, i.e. with respect to the top side 10 and the bottom side 11. Thus, the secondary lateral side 13 is any side of the given space that is not the top side 10, the bottom side 11, the main lateral side 12 or the base 2. The tertiary lateral side 14 is any side of the given space that is not the top side 10, the bottom side 11, the main lateral side 12, the base 2 for the secondary lateral side 13.

The base 2 is in contact with the object to be cooled, supports the plate fins 3 and conducts the heat away from the object to be cooled to the plate fins 3. The heatsink 1 can be manufactured by die casting or by soldering or welding plate fins 3 to the base 2. Copper and aluminum are examples of suitable materials for the heatsink 1, but other materials can also be used.

A channel 4 is formed between pairs of neighboring plate fins 3. A channel 4 allows air to flow along the fins 3 so that heat can be dissipated from the plate fins to the air.

The bottom of a channel 4 is formed by the base 2 and the channels 4 are either open or closed along part of all of their length towards the main lateral side 12.

At least one pair of neighboring plate fins 3 forms a channel 4 of a first type that extends between the bottom side 11 and the top side 10. The channel 4 of the first type allows air to enter from the bottom side 11 into the channel 4 and to flow, driven by convection, through the channel 4 towards the top face 10, exiting the channel from the top face 10.

At least one pair of neighboring plate fins 3 forms a channel 4 of a second type that extends between the secondary lateral side 13 and the top side 10. The channel 4 of the second type allows air to enter from the secondary lateral side 13 into the channel 4 and to flow, driven by convection, through the channel 4 towards the top face 10, exiting the channel from the top face 10.

The channels of a first type open to the bottom side 11 and to the top side 10. The channels of the second type open to the secondary lateral side 13 and to the top side 10.

Thus, in the ambient air for flowing through the channels 4 defined between the neighboring pairs of plate fins 3 can enter from the bottom face 11 and from the secondary lateral face 13, thereby improving the capacity of the heatsink 1 to dissipate heat to the ambient air.

In the present embodiment the number of first type channels 4 and second type channels 4 is roughly equal, but this is not a prerequisite and the distribution between the two types of channels 4 can be unequal.

The heatsink 1 is equipped with two types of plate fins 3. The first type of plate fins extends lengthwise from the bottom side 11 to the top side 10. The second type of plate fin extends lengthwise from the secondary lateral side 13 into the given space in a direction that includes a component towards the top side 10. Preferably, at least one of the plate fins 3 of the second type extends from the secondary lateral side 13 to the top side 10.

The plate fins 3 of the first type can start from the bottom side 11 in a straight line that is either parallel with the secondary lateral side 13 or at a slight angle there with.

The plate fins 3 of the second type start from the secondary lateral side 13 at sharp an angle with the secondary lateral side 13.

The plate fins 3 of the first type and the plate fins 3 of the second type are in this embodiment divided in two straight sections with the longitudinal extent of the two straight sections arranged in different directions, i.e. at an angle relative to one another.

However, it is noted that is also possible to use curved plate fins of the first type and/or curved plate fins of the second type. It is also noted that the plate fins 3 of the first type can be straight along all of their length. The plate fins 3 of the second type can also be straight along all of their length.

In the present embodiment the plate fins 3 of both the first type plate fins and the second type plate fins in an upper portion 15 of the heatsink 1 nearest to the top side 10 extend parallel with one another in a direction that is preferably substantially perpendicular to the top side 10. However, this is not a prerequisite and none of the plate fins 3 needs to extend exactly in the direction from the top to the bottom (top and bottom as in the orientation in Figs. 3 and 4).

The heatsink 1 according to the present embodiment is equipped with plate fins 3 that extend lengthwise from the secondary lateral side 13 and terminate before reaching another side of the given space. The heatsink 1 according to the present embodiment is equipped with plate fins 3 that extend lengthwise from the bottom side 11 and terminate before reaching another side of the given space.

In the present embodiment the plate fins 3 are secured to a first side of the base 2 and extend parallel with the normal vector to the first side of the base 2 at the position where a plate fin 3 concerned is secured to the base 2.

The heatsink 1 can be provided with means for ensuring that the heatsink 1 can only be installed in one intended orientation, relative to the printed circuit board 5 that it is to be installed on, in order to ensure that the orientation of the plate fins 3 and channels 4 relative to the direction of the gravitational pull of the earth will be correct and is intended, in particular in relation to the direction of convection. The printed circuit board 5 and any unit it may be installed in may also be provided with means for ensuring installation in the intended orientation.

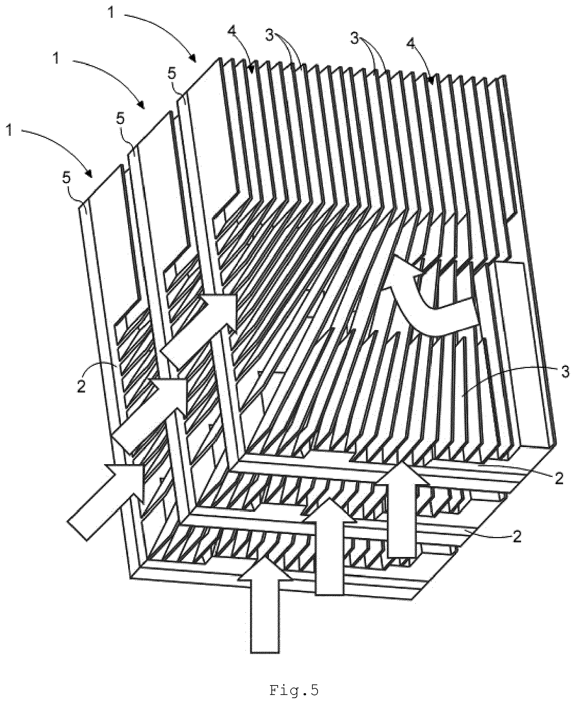

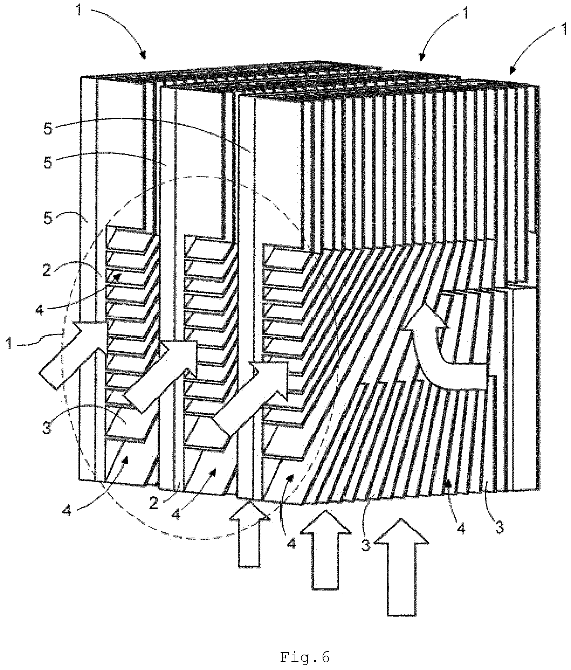

Fig. 5 and 6 illustrate an assembly of a plurality of closely spaced heatsinks 1. The heatsinks 1 are mounted on printed circuit boards 5 that are arranged in close parallel relationship, with the printed circuit boards 5 extending vertically and the top sides 10 facing upwardly (upward as relative to the gravitational pull of the earth) and the bottom sides 11 facing downwardly (downward as relative to the gravitational pull of the earth). Thus, the lateral side 12 of one heatsink 1 faces the base 2 of the neighboring heatsink 1 (except for the one heatsink 1 on and outermost position in the assembly).

The large fat arrows in Figs. 5 and 6 illustrate examples of the positions at which ambient air can enter the channels 4. As can be seen in Figs. 5 and 6, the ambient air can enter through the bottom sides 11, through the secondary lateral sides 13, and for the heatsink 1 in the outermost position the in ambient air can also enter through the primary lateral side 12. Especially for the heatsinks 1 that are sandwiched between 2 printed circuit boards 5 there is a clear increase in the capacity to take in ambient air and thereby dissipate heat from the plate fins 3 to the ambient air.

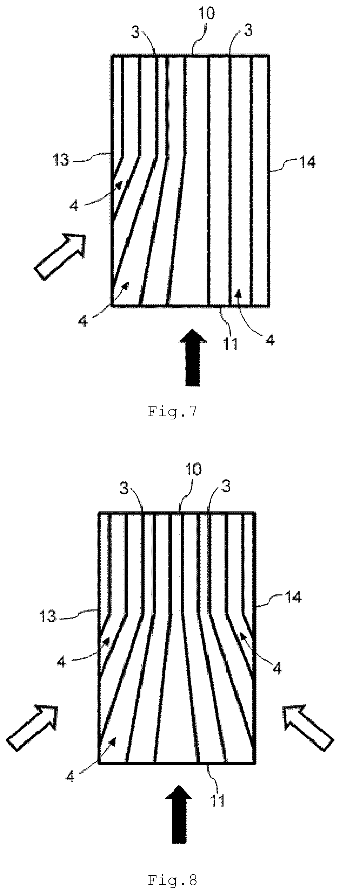

Fig. 7 shows a second embodiment that is essentially identical with the heat exchanger 1 of the first embodiment, except that a larger number of the first type plate fins 3 extends straight from the bottom side 11 to the top side 10.

Fig. 8 shows a third embodiment that is essentially identical with the heat exchanger of the first and second embodiment, except that it is equipped with a third type of channel 4 and a third type of plate fin 3. The third type of channel for extends between the tertiary lateral side 14 and the top side 10. The third type plate fin extends between the tertiary lateral side 14 and top side 10. Thus, the heat exchanger 1 can take also ambient air in via the tertiary side 14.

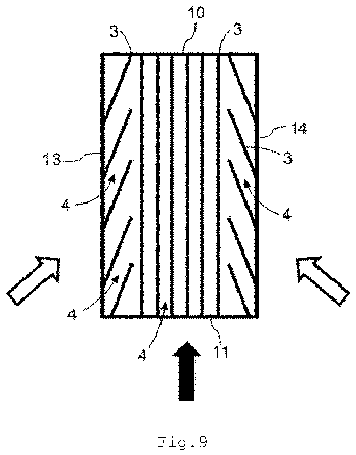

Fig. 9 shows a fourth embodiment that is essentially identical with the third embodiment, except that most of the plate fins 3 that start at either the secondary lateral side 13 or at the tertiary lateral side 14 and before they reach another side of the given space. In the fourth embodiment only the uppermost plate fin 3 that starts from the secondary lateral side 13 extends all the way to the top face 10. Similarly, only the uppermost plate fin 3 that starts from the tertiary lateral side 14 extends all the way to the top face 10. In this embodiment the second and third type channels for merged into one channel that opens to the upper face 10. This channel has several inlets at the secondary lateral side 13 and one at the bottom side 11 or the one channel several inlets at the tertiary lateral side 14 and one at the bottom side 11.

The invention has been described in conjunction with various embodiments herein. However, other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. The reference signs used in the claims shall not be construed as limiting the scope.

## Claims

1. A heatsink (1) for natural convection cooling, said heatsink comprising:
a plurality of spaced plate fins (3) projecting from a base (2) with a given height (h), said plate fins (3) having a given length and said plate fins (3) being arranged to occupy a given space,
said given space having a bottom side (11), a top side (10), a main lateral side (12) connecting said top side (10) and said bottom side (11), a secondary lateral side (13) connecting said top side (10) and said bottom side (11), and a tertiary lateral side (14), said tertiary lateral side (14) opposing said secondary lateral side (13), and said main lateral side (12) connects said secondary lateral (13) side and said tertiary lateral side (14),
channels (4) for allowing air to flow along said plate fins (3), the channels (4) being formed between pairs of neighboring plate fins (3) with a bottom of the channels (4) being formed by said base (2) and said channels (4) being open or closed along all or part of their length to said main lateral side (12), and wherein the channels comprise channels of a first type and a second type,
at least one pair of neighboring plate fins (3) forms a channel (4) of said first type that extends between said bottom side (11) and said top side (10) and opening said bottom side (11) to said top side (10), and
at least one pair of neighboring plate fins (3) forms a channel (4) of said second type that extends between said secondary lateral side (13) and said top side (10) and opening said secondary lateral side (13) to said top side (10),
at least one of the plate fins (3) of said plurality of spaced plate fins is a plate fin (3) of a first type that extends lengthwise from said bottom side (11) to said top side (10), at least one of the plate fins (3) of said plurality spaced plate fins being plate fins (3) of a second type that extends lengthwise from said secondary lateral side (13) into said given space in a direction that includes a component towards said top side (10), and **characterised in that**:
a portion of the plate fins (3) of both the first type plate fins and the second type plate fins in an upper portion (15) of the heatsink (1) closest to the top side (10) extend parallel with one another in a direction that is preferably substantially perpendicular to said top side (10).

2. A heatsink according to claim 1, wherein at least one of said plate fins (3) of said second type extends from said secondary lateral side (13) to said top side (10).

3. A heatsink (1) according to any one of claims 1 to 2, comprising a plate fin (3) that extends lengthwise from the secondary lateral side (13) or from the bottom side (11) and terminates before reaching another side of said given space.

4. A heatsink according to any one of claims 1 to 3, wherein at least one pair of neighboring plate fins (3) forms a channel (4) of a third type that extends between said tertiary lateral side (14) and said top side (10).

5. An assembly of a plurality of adjacent heatsinks (1) according to any one of claims 1 to 4.

6. An assembly according to claim 5, wherein the main lateral side (12) of one heatsink (1) faces the base (2) of the neighboring heatsink (1).

7. An assembly according to claim 5 or 6, wherein a first heatsink (1) is mounted on a first printed circuit board (2), and a second heatsink is mounted on a second printed circuit board (2), with the first and second printed circuit boards (2) extending parallel with one another.

## Patentansprüche

1. Wärmesenke (1) für eine natürliche Konvektionskühlung, wobei die Wärmesenke umfasst:
eine Vielzahl von beabstandeten Plattenrippen (3), die von einer Basis (2) vorstehen, mit einer gegebenen Höhe (h), wobei die Plattenrippen (3) eine gegebene Länge aufweisen und die Plattenrippen (3) angeordnet sind, um einen gegebenen Raum einzunehmen,
wobei der gegebene Raum eine Bodenseite (11), eine Oberseite (10), eine primäre laterale Seite (12), die die Oberseite (10) und die Bodenseite (11) verbindet, eine sekundäre laterale Seite (13), die die Oberseite (10) und die Bodenseite (11) verbindet, und eine tertiäre laterale Seite (14) aufweist, wobei die tertiäre laterale Seite (14) der sekundären lateralen Seite (13) gegenüberliegt, und die primäre laterale Seite (12) die sekundäre laterale (13) Seite und die tertiäre laterale Seite (14) verbindet, Kanäle (4) zum Ermöglichen, dass Luft entlang der Plattenrippen (3) strömt, wobei die Kanäle (4) zwischen Paaren benachbarter Plattenrippen (3) ausgebildet sind, wobei ein Boden der Kanäle (4) durch die Basis (2) ausgebildet ist und die Kanäle (4) entlang der gesamten oder eines Teils ihrer Länge zu der primären lateralen Seite (12) offen oder geschlossen sind, und wobei die Kanäle Kanäle einer ersten Art und einer zweiten Art umfassen,
wobei mindestens ein Paar benachbarter Plattenrippen (3) einen Kanal (4) der ersten Art, der sich zwischen der Bodenseite (11) und der Oberseite (10) erstreckt und die Bodenseite (11) zu der Oberseite (10) öffnet, ausbildet, und
wobei mindestens ein Paar benachbarter Plattenrippen (3) einen Kanal (4) der zweiten Art, der sich zwischen der sekundären lateralen Seite (13) und der Oberseite (10) erstreckt und die sekundäre laterale Seite (13) zu der Oberseite (10) öffnet, ausbildet, wobei mindestens eine der Plattenrippen (3) der Vielzahl von beabstandeten Plattenrippen eine Plattenrippe (3) einer ersten Art, die sich der Länge nach von der Bodenseite (11) zu der Oberseite (10) erstreckt, ist,
wobei mindestens eine der Plattenrippen (3) der Vielzahl von beabstandeten Plattenrippen Plattenrippen (3) von einer zweiten Art ist, die sich der Länge nach von der sekundären lateralen Seite (13) in den gegebenen Raum in einer Richtung, die eine Komponente einschließt, zu der Oberseite (10) hin erstreckt, und **dadurch gekennzeichnet, dass**:
sich ein Abschnitt der Plattenrippen (3) sowohl der Plattenrippen der ersten Art als auch der Plattenrippen der zweiten Art in einem oberen Abschnitt (15) der Wärmesenke (1), der der Oberseite (10) am nächsten liegt, parallel zueinander in einer Richtung, die vorzugsweise im Wesentlichen senkrecht zu der Oberseite (10) ist, erstrecken.

2. Wärmesenke nach Anspruch 1, wobei sich mindestens eine der Plattenrippen (3) der zweiten Art von der sekundären lateralen Seite (13) zu der Oberseite (10) erstreckt.

3. Wärmesenke (1) nach einem der Ansprüche 1 bis 2, die eine Plattenrippe (3), die sich der Länge nach von der sekundären lateralen Seite (13) oder von der Bodenseite (11) erstreckt und vor einem Erreichen einer anderen Seite des gegebenen Raums endet, umfasst.

4. Wärmesenke nach einem der Ansprüche 1 bis 3, wobei mindestens ein Paar benachbarter Plattenrippen (3) einen Kanal (4) einer dritten Art ausbildet, der sich zwischen der tertiären lateralen Seite (14) und der Oberseite (10) erstreckt.

5. Anordnung einer Vielzahl von angrenzenden Wärmesenken (1) nach einem der Ansprüche 1 bis 4.

6. Anordnung nach Anspruch 5, wobei die primäre laterale Seite (12) einer Wärmesenke (1) der Basis (2) der benachbarten Wärmesenke (1) zugewandt ist.

7. Anordnung nach Anspruch 5 oder 6, wobei eine erste Wärmesenke (1) auf einer ersten Leiterplatte (2) montiert ist und eine zweite Wärmesenke auf einer zweiten Leiterplatte (2) montiert ist, wobei sich die erste und die zweite Leiterplatte (2) parallel zueinander erstrecken.

## Revendications

1. Puits thermique (1) pour le refroidissement par convection naturelle, ledit puits thermique comprenant :
une pluralité d'ailettes de plaque (3) espacées faisant saillie à partir d'une base (2) avec une hauteur donnée (h), lesdites ailettes de plaque (3) ayant une longueur donnée et lesdites ailettes de plaque (3) étant agencées pour occuper un espace donné,
ledit espace donné ayant un côté inférieur (11), un côté supérieur (10), un côté latéral principal (12) reliant ledit côté supérieur (10) et ledit côté inférieur (11), un côté latéral secondaire (13) reliant ledit côté supérieur (10) et ledit côté inférieur (11), et un côté latéral tertiaire (14), ledit côté latéral tertiaire (14) opposé audit côté latéral secondaire (13), et ledit côté latéral principal (12) relie ledit côté latéral secondaire (13) et ledit côté latéral tertiaire (14),
des canaux (4) pour permettre à l'air de s'écouler le long desdites ailettes de plaque (3), les canaux (4) étant formés entre des paires d'ailettes de plaque (3) voisines avec un fond des canaux (4) étant formé par ladite base (2) et lesdits canaux (4) étant ouverts ou fermés le long de tout ou partie de leur longueur à ladite face latérale principale (12), et les canaux comprenant des canaux d'un premier type et d'un deuxième type,
au moins une paire d'ailettes de plaque (3) voisines forme un canal (4) dudit premier type qui s'étend entre ledit côté inférieur (11) et ledit côté supérieur (10) et ouvrant ledit côté inférieur (11) audit côté supérieur (10), et
au moins une paire d'ailettes de plaque (3) voisines forme un canal (4) dudit deuxième type qui s'étend entre ledit côté latéral secondaire (13) et ledit côté supérieur (10) et ouvrant ledit côté latéral secondaire (13) audit côté supérieur (10),
au moins l'une des ailettes de plaque (3) de ladite pluralité d'ailettes de plaque espacées est une ailette de plaque (3) d'un premier type qui s'étend longitudinalement depuis ledit côté inférieur (11) vers ledit côté supérieur (10),
au moins une des ailettes de plaque (3) de ladite pluralité d'ailettes de plaque espacées étant des ailettes de plaque (3) d'un second type qui s'étend longitudinalement à partir dudit côté latéral secondaire (13) dans ledit espace donné dans une direction qui comporte un composant vers ledit côté supérieur (10), et
**caractérisé en ce que :**
une partie des ailettes de plaque (3) à la fois des ailettes de plaque de premier type et des ailettes de plaque de second type dans une partie supérieure (15) du puits thermique (1) le plus proche du côté supérieur (10) s'étendent parallèlement les unes aux autres dans une direction qui est de préférence sensiblement perpendiculaire audit côté supérieur (10).

2. Puits thermique selon la revendication 1, dans lequel au moins une desdites ailettes de plaque (3) dudit second type s'étend depuis ledit côté latéral secondaire (13) vers ledit côté supérieur (10).

3. Puits thermique (1) selon l'une quelconque des revendications 1 à 2, comprenant une ailette de plaque (3) qui s'étend en longueur depuis le côté latéral secondaire (13) ou depuis le côté inférieur (11) et se termine avant d'atteindre un autre côté dudit espace donné.

4. Puits thermique selon l'une quelconque des revendications 1 à 3, dans lequel au moins une paire d'ailettes de plaque (3) voisines forme un canal (4) d'un troisième type qui s'étend entre ledit côté latéral tertiaire (14) et ledit côté supérieur (10).

5. Ensemble d'une pluralité de puits thermiques adjacents (1) selon l'une quelconque des revendications 1 à 4.

6. Ensemble selon la revendication 5, dans lequel le côté latéral principal (12) d'un puits thermique (1) fait face à la base (2) du puits thermique (1) voisin.

7. Ensemble selon la revendication 5 ou 6, dans lequel un premier puits thermique (1) est monté sur une première carte à circuit imprimé (2), et un second puits thermique est monté sur une seconde carte à circuit imprimé (2), avec les première et seconde cartes de circuit imprimé (2) s'étendant parallèlement l'une à l'autre.
